# EUROPEAN PATENT APPLICATION

(11) **EP 2 413 368 A2**
(43) Date of publication of application: **01.02.2012**
(21) Application number: 11175497.4
(22) Date of filing: 27.07.2011
(51) Int. Cl.: H01L 31/0216, H01L 31/18

(54) **Charge control of solar cell passivation layers**

(30) Priority: 27.07.2010 US 844746
(71) Applicant: AMTECH SYSTEMS, INC., Arizona 85281 (US)
(72) Inventor: Hwang, Jeong-Mo, San Jose, CA 95128 (US)
(74) Representative: Pallini, Diego

(57) **Abstract**

The present invention relates to the charge control of the front and back passivation layers of a solar cell, which allows a common passivation material to be used on both the front and back surfaces of a solar cell. A solar cell according to one embodiment of the present invention comprises an emitter and a base. The cell further includes a first passivation layer adjacent the emitter, the first passivation layer having a charge. The cell also includes a second passivation layer adjacent the base, the second passivation layer having a charge opposite to the charge of the first passivation layer, wherein the first passivation layer and the second passivation layer include a common passivation material. The first and second passivation layers can include any suitable dielectric material capable of holding either a positive or a negative charge, and each of the first and second passivation layers can be charged at any suitable point during manufacture of the cell, including during or after deposition of the passivation layer(s).

## Description

### DESCRIPTION OF THE INVENTION

### Field of the Invention

The present invention relates to charge control of passivation layers for semiconductors, particularly in solar cell applications, and to semiconductors including such passivation layers.

### Background of the Invention

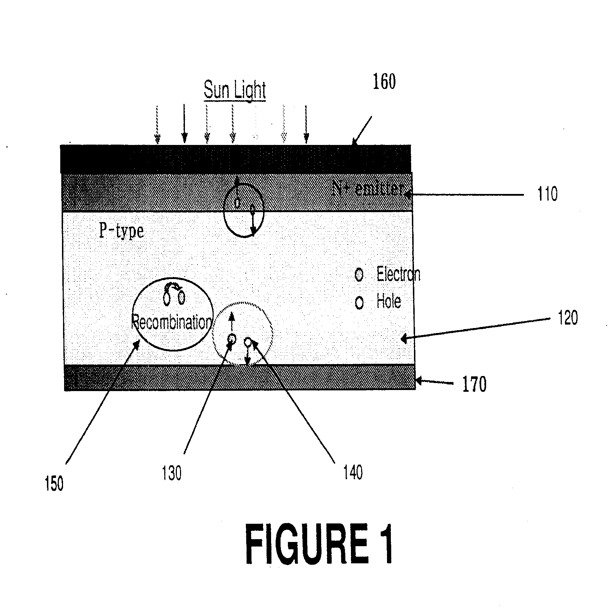

Solar cells (also known as photovoltaic cells) convert light energy into electricity. Figure 1 illustrates a common solar cell 100 that includes n-type semiconductor layer 110 in contact with a thick p-type semiconductor layer (substrate) 120. The interface of these layers is known as a "p-n junction." This type of a p-type substrate solar cell is called a p-type cell. In p-type semiconductors, the hole (the absence of valence electrons) is the majority carrier and the free electron is the minority carrier. In n-type semiconductors, by contrast, the electron is the majority carrier and the hole is the minority carrier. As a photon (e.g., from sunlight) with an energy higher than the semiconductor band-gap enters the cell 100, it is absorbed by generating a free electron 130 and hole 140 pair in the cell 100. Sunlight contains photons with a wide range of energies form infra-red to ultraviolet. Higher energy photons (or shorter wave-length light) are absorbed near the semiconductor surface while lower energy photons (or long wavelength light) penetrate to deeper regions of the substrate. Photo-generated minority-carrier electrons 130 in the p-type semiconductor layer 120 move toward the p-n junction by diffusion and collect to the n-type layer, which causes an electrical current. Electrons 130 and holes 140 in the cell tend to "recombine" (150) with each other, particularly at defect sites. As electrons and holes recombine, however, they cease to contribute to the electrical current generation, thereby decreasing the efficiency of the solar cell.

Photo-generated minority carriers (i.e., holes in n-type semiconductors or electrons in p-type semiconductors) tend to recombine more quickly through surface defects formed by the abrupt termination of the semiconductor material at the front and back surfaces of the semiconductor. This phenomenon is often referred to as "surface recombination" and is measured in surface recombination velocity.

In thinner semiconductor wafers, which many manufacturers seek to produce in order to reduce the cost of manufacturing solar cells, surface recombination (particularly at the back surface) is more significant, while bulk recombination becomes less significant. The thinner the semiconductor, the greater the number of photo-generated carriers at the back surface, while the loss of photo-generated minority carriers due to bulk recombination decreases because the semiconductor thickness becomes comparable to or smaller than the minority-carrier diffusion length. In thin semiconductors, therefore, the efficiency loss due to back surface recombination has a greater effect on the total efficiency of the solar cell.

Referring again to Figure 1, it is known to apply a coating 160 to the front surface of a solar cell to act as both an antireflective coating and a passivation layer to help prevent electron/hole recombination on the surface. Where the top surface of a solar cell comprises an n-type semiconductor, the coating 160 often includes silicon nitride (SiN), which is typically applied using a process known as plasma-enhanced chemical vapor deposition (PECVD). PECVD SiN normally includes a large density of positive charges, and while it is a suitable coating for the n-type portion of a solar cell (such as the N+ emitter 110 in Figure 1), SiN is not a good choice for coating the p-type portion of a solar cell (such as the P-type base 120 in Figure 1) because the positive charge density of PECVD SiN tends to interact with the p-type material to cause a detrimental effect known as "parasitic shunting." See Surface Passivation of High-efficiency Silicon Solar Cells by Atomic-layer-deposited Al2O3, J. Schmidt et al., Prog. Photovolt: Res. Appl. 2008; 16:461-466 at 462. Instead, it is known to use aluminum oxide (Al₂O₃), which is known to normally have a high density of negative charge, as the passivation layer 170 for a P-type base 120. Id. Therefore, a different passivation layer other than SiN is used for p-type base 120. However, it can be more costly to maintain two different configurations of deposition equipment in order to apply two different passivation materials for the front and back surfaces of a solar cell. The present invention addresses these and other issues.

### SUMMARY OF THE INVENTION

The present invention allows the same passivation material to be used on both the front and back surfaces of a solar cell. A solar cell according to one embodiment of the present invention comprises an emitter and a base. The cell further includes a first passivation layer adjacent to the emitter, the first passivation layer having a charge. The cell also includes a second passivation layer adjacent to the base, the second passivation layer having a charge opposite to the charge of the first passivation layer, wherein the first passivation layer and the second passivation layer include a common passivation material. The first and second passivation layers can include any suitable dielectric material capable of holding either a negative or a positive charge, and each of the passivation layers can be charged at any suitable point during manufacture of the cell, including during or after deposition of the passivation layer(s).

### BRIEF DESCRIPTION OF THE DRAWINGS

Figure 1 illustrates the configuration of a conventional solar cell.

Figures 2, 3, and 4 illustrate exemplary embodiments of solar cells according to various aspects of the present invention.

### DETAILED DESCRIPTION OF PREFERRED EMBODIMENTS

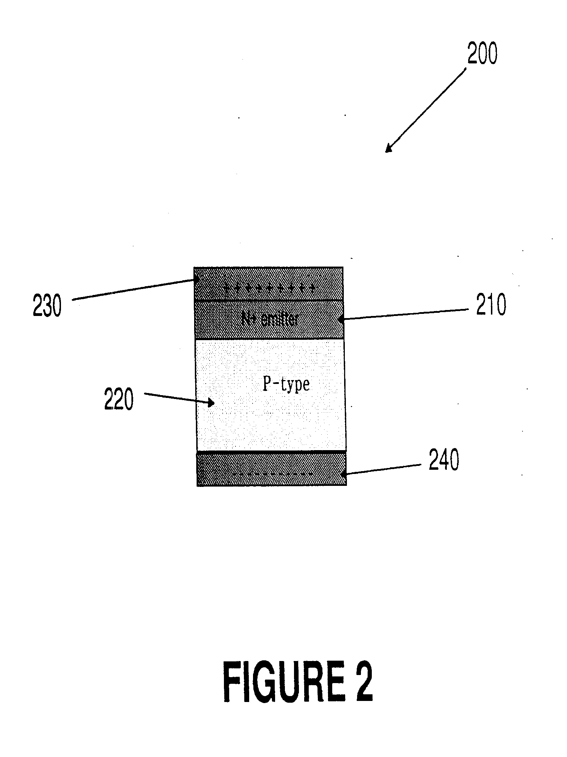

A solar cell according to one embodiment of the present invention is depicted in Figure 2. In this exemplary embodiment, solar cell 200 is an N-type cell which includes an emitter 210 comprising an N-type semiconductor layer (also known as an "N+ emitter") and a base 220 comprising a P-type semiconductor substrate. The cell 200 further includes a first passivation layer 230 adjacent to the emitter 210, and a second passivation layer 240 adjacent to the base 220. Figure 2 also shows the desired charge types in the passivation layers (230, 240) for more effective surface passivation and thus higher cell efficiency, namely a positive charge in the front passivation layer 230 and a negative charge in the back passivation layer 240.

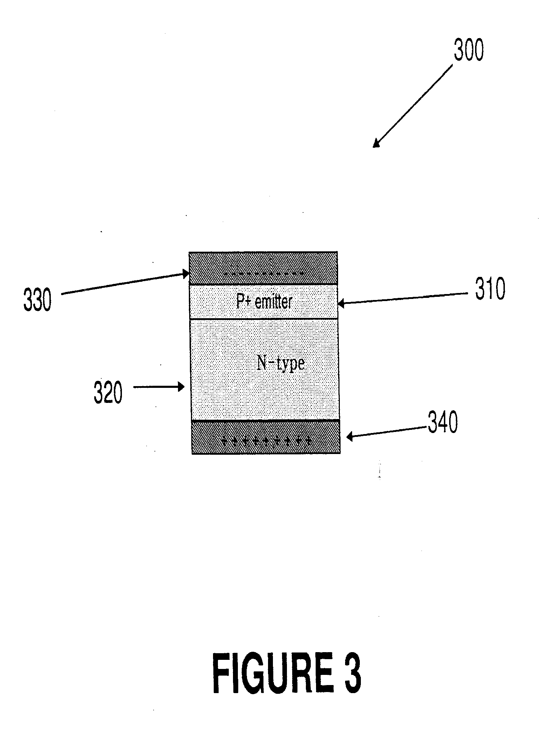

Figure 3 depicts another exemplary embodiment of a solar cell according to aspects of the present invention. In this exemplary embodiment, solar cell 300 includes an emitter 310 comprising a P-type semiconductor layer (also known as an "P+ emitter") and a base 320 comprising an N-type semiconductor layer. Solar cell 300 may also be referred to as a "P-type cell." The cell 300 further includes a first passivation layer 330 adjacent to the emitter 310, and a second passivation layer 340 adjacent to the base 320. Figure 3 also shows a negative charge in the front passivation layer 330 and positive charge in the back passivation layer 340.

In the exemplary solar cells 200 and 300, the N+ emitter 210 and N-type base 320 each include a semiconductor doped with an N-type dopant (such as phosphorous or arsenic for a silicon semiconductor), while the P-type base 220 and P+ emitter 310 each include a semiconductor doped with a P-type dopant such as boron. In addition to silicon, emitters 210, 310 and bases 220, 320 may be formed from any suitable semiconducting material(s), such as germanium, gallium arsenide, and/or silicon carbide, as is known by those skilled in the art. In addition, in the exemplary solar cells 200 and 300, a thin silicon di-oxide (SiO2, also referred to as "oxide") interfacial layer can be added between the charged passivation layer and the semiconductor surface for further improvement of front and back surface passivation.

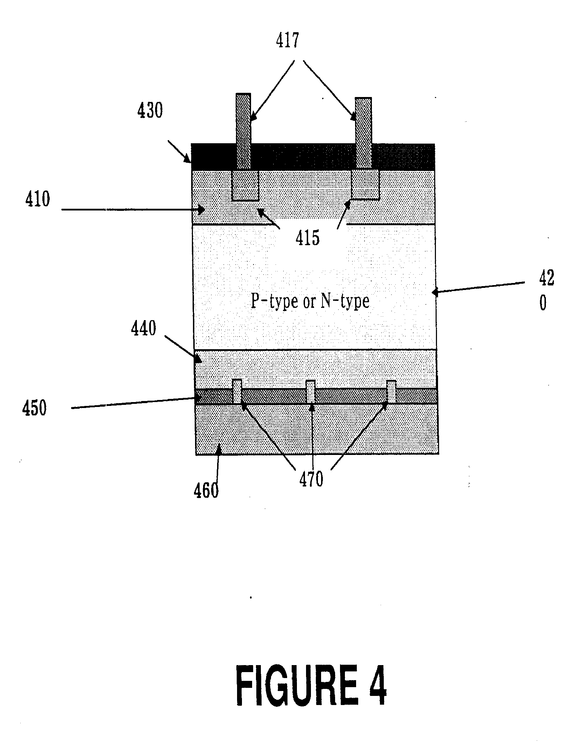

In Figures 2 and 3, emitters 210, 310 and bases 220, 320 are depicted as layers of uniform thickness, but emitters 210, 310 and bases 220, 320 may be any suitable, respective size, shape, or configuration. Figure 4 depicts another exemplary solar cell configuration that may be used in conjunction with the present invention. In this embodiment, solar cell 400 includes a lightly-doped semiconductor region 410 formed on a semiconductor substrate 420. Selective emitters 415 are formed from heavily-doped semiconductor portions 415 (of the same type as the lightly-doped emitter) are formed in contact with metal (e.g., silver) grids 417. Substrate 420 is coupled to a back-surface field (BSF) region 440 of the same type as the base 420, which is formed by heavily doping the back surface of the wafer. Cell 400 further includes an antireflective coating and passivation layer 430 (such as silicon nitride) on its front surface, and a passivation layer 450 on its back surface. In this exemplary embodiment, passivation layer 450 may include silicon dioxide or silicon nitride. A metal layer 460 (formed from aluminum, for example) is coupled to the BSF layer 440 via contact holes 470. The present invention may be utilized in conjunction with any other suitable solar cell configuration. For example, in some embodiments of the present invention, the back surface field layer 440 need not cover the entire back surface area of a wafer, which simplifies (and reduces the cost of) the manufacturing process by reducing or eliminating the high-temperature diffusion process required for formation of the back surface field layer formation. This is possible because an appropriately added charge to the back passivation layer (negative charge in the case of the P-type base) accumulates majority carriers (holes in this case), forming an effective back surface field layer without a heavy doping diffusion process.

In embodiments of the present invention, the passivation layer adjacent to the emitter of a solar cell (e.g., passivation layers 230, 330, or 430) and the passivation layer adjacent the base (e.g., passivation layers 240, 340, or 450) each include a common passivation material. Among other things, this allows for solar cells to be manufactured in a more cost-effective manner than cells having different passivation materials on their front and back surfaces. While the silicon nitride (Si3N4) is most preferred, any suitable passivation material capable of storing a charge may be used in conjunction with the present invention, including aluminum oxide (Al2O3), zirconium oxide (ZrO2), and/or hafnium oxide (HfO2). The front and back passivation layers may be formed partially, or entirely, from a single passivation material.

The front and back passivation layers may be any desired size, shape, configuration, or thickness. In one embodiment, a solar cell according to aspects of the present invention includes a front passivation layer and back passivation layer each having silicon nitride with a thickness of about 800 Ǻ, though the front and back passivation layers need not be of the same size, shape, configuration, thickness, or include the same percentage of passivation material.

It is known to use SiN as a material for storing a charge in the silicon nitride layer of Silicon-Oxide-Nitride-Oxide-Silicon (SONOS) non-volatile memories. In SONOS non-volatile operation, a positive biasing to a control gate with respect to silicon substrate causes the S3iN4 layer to store a negative charge. Conversely, a negative biasing to the control gate causes the Si3N4 layer to store a positive charge.

In solar cells, however, since there is no gate electrode to which an external bias can be applied in order to charge a SiN passivation layer, a different charging method has to be used. In one embodiment of the present invention, passivation layers of a charge-storing material that can store either a positive or negative charge (such as Si3N4) can be applied to both the front and back (e.g., layers 230 and 240, respectively) of a solar cell, and either passivation layer positively or negatively charged, as desired. Either the front or back passivation layer of a solar cell can be charged, either positively or negatively, at any suitable point during the manufacture of the solar cell. For example, a charging apparatus may be added to a PECVD deposition tool to charge the passivation material (e.g., Si3N4) in situ. Alternatively, the passivation layers of a solar cell may be charged by a stand-alone tool during processing of the solar cell. The passivation layers may also be charged separately or simultaneously.

The passivation layers of a solar cell may be charged in any suitable manner. In one embodiment, charging of the passivation layer(s) is performed using a process known as "corona charging." In this process, the passivation layer material is given a positive or negative charge by corona discharging current which is generated when a high voltage is applied between two electrode such that a gas in between the two electrodes is ionized. In the case of a solar cell, the semiconductor body (wafer) is electrically connected to one electrode (typically grounded). To establish an electrical connection of semiconductor the body to one electrode, one side of the semiconductor surface (front or back) has the passivation layer to be charged whereas the other side has either no insulating material (including a passivation layer) or metal grids connected to the semiconductor body. Charging takes place on one-side passivation material at a time. The simultaneous charging of the front and back passivation layers can also be performed if a sufficiently high charging voltage and charging time of sufficient duration are provided. In this charging process, the desired charges (electrons or holes) are injected from the adjacent semiconductor into the dielectric passivation layer by a strong electric field across the passivation layer(s) generated by a high-voltage corona discharging. The injected electrons or holes are stored (or trapped) through the passivation layer with a density peak near the semiconductor interface. Depending on the corona bias direction with respect to the solar cell wafer, undesired positive ions (generated from the corona discharging) are deposited on the surface of a passivation layer. These surface positive ions are preferably removed for the stored charges to play a desired effective role. One simple way of removing the positive ions is to apply an opposite direction of a high corona voltage bias and to discharge them with electrons for a short time.

In another embodiment, charging of the passivation layer(s) can be performed using "plasma charging." Many semiconductor processing equipment, such as reactive ion etchers (RIE), and plasma-enhanced chemical vapor deposition (PECVD) tools use a plasma (a gas mixture of positive ions and electrons), which is typically generated through gas ionization in a chamber by a high-frequency power horizontally applied from the chamber wall. Ions are separated from electrons by a low-frequency, high-voltage vertical power, and are used for etching or deposition depending on tool configuration. By optimizing the low-frequency high-voltage vertical power source, the plasma con be used for the charging of the solar cell passivation layer(s).

The particular implementations shown and described above are illustrative of the invention and its best mode and are not intended to otherwise limit the scope of the present invention in any way. Indeed, for the sake of brevity, conventional data storage, data transmission, and other functional aspects of the systems may not be described in detail. Methods illustrated in the various figures may include more, fewer, or other steps. Additionally, steps may be performed in any suitable order without departing from the scope of the invention. Furthermore, the connecting lines shown in the various figures are intended to represent exemplary functional relationships and/or physical couplings between the various elements. Many alternative or additional functional relationships or physical connections may be present in a practical system.

Changes and modifications may be made to the disclosed embodiments without departing from the scope of the present invention. These and other changes or modifications are intended to be included within the scope of the present invention, as expressed in the following claims.

## Claims

1. A solar cell comprising:
- an emitter;
- a base;
- a first passivation layer adjacent the emitter, the first passivation layer having a charge; and
- a second passivation layer adjacent the base, the second passivation layer having a charge opposite to the charge of the first passivation layer, wherein the first passivation layer and the second passivation layer include a common passivation material.

2. The solar cell of claim 1 wherein the emitter is:
an N-type emitter, the base is a P-type base, the first passivation layer is positively charged, and the second passivation layer is negatively charged; or
a P-type emitter, the base is an N-type base, the first passivation layer is negatively charged, and the second passivation layer is positively charged.

3. The solar cell of claim 1 wherein the first passivation layer is in direct contact with the emitter and/or the second passivation layer is in direct contact with the base.

4. The solar cell of claim 1 further comprising a back surface filled (BSF) layer in direct contact with the second passivation layer.

5. The solar cell of claim 1 wherein the common passivation material includes silicon nitride (Si₃N₄); preferably the first passivation layer and the second passivation layer each consist essentially of Si₃N₄.

6. The solar cell of claim 1 wherein the common passivation material includes aluminum oxide (Al₂O₃); preferably the first passivation layer and the second passivation layer each consist essentially of Al₂O₃.

7. The solar cell of claim 1 wherein the common passivation material includes zirconium oxide (ZrO₂) preferably the first passivation layer and the second passivation layer each consist essentially of ZrO₂.

8. The solar cell of claim 1 wherein the common passivation material includes hafnium oxide (HfO₂), Preferably the first passivation layer and the second passivation layer each consist essentially of HfO₂.

9. The solar cell of claim 1 wherein the emitter comprises an N+ emitter or a P+ emitter.

10. The solar cell of claim 1 wherein the base includes a P-type semiconductor Or an N-type semiconductor.

11. The solar cell of claim 1 wherein the first passivation layer and the second passivation layer are each deposited using plasma enhanced chemical vapor deposition.

12. The solar cell of claim 1 wherein the first passivation layer has a thickness of about 800Å and/or the second passivation layer has a thickness of about 800Å.

13. The solar cell of claim 1 further comprising:
a first thin interfacial layer between the first passivation layer and the emitter; and
a second thin interfacial layer between the second passivation layer and the base.

14. The solar cell of claim 1 wherein each of the first passivation layer and second passivation layer is charged using one of the group consisting of: corona charging and plasma charging.

15. The solar cell of claim 1 wherein each of the first passivation layer and second passivation layer is charged in situ, or by a stand-alone tooland/or are charged separately, and/or are charged simultaneously.

16. A solar array including one or more solar cells as defined in claim 1.

17. The solar cell of claim 1 wherein the bottom surface further includes a cathode, and/or the top surface further includes an anode.

18. The solar cell of claim 1 that further includes leads through which electrical current can flow.
